# EUROPEAN PATENT APPLICATION

(11) **EP 4 797 936 A1**
(43) Date of publication of application: **26.08.2026**
(21) Application number: 26160497.9
(22) Date of filing: 24.02.2026
(51) Int. Cl.: H10W 70/40, H10W 72/90, H10W 90/00, H10W 70/698, H10B 80/00, H10W 72/59, H10W 72/50, H10W 70/685, H10W 70/04

(54) **CONNECTION BOARD FOR FLASH MEMORY CHIP AND PREPARATION METHOD THEREFOR, AND FLASH MEMORY CHIP**

(30) Priority: 25.02.2025 CN 202510213563
(71) Applicant: GIGADEVICE SEMICONDUCTOR (XIAN) INC., Xi'an, Shaanxi 710065 (CN)
(72) Inventor: Fu, Leilei, Xi'an City 710065 (CN); Li, Yuanyuan, Xi'an City 710065 (CN); Wang, Pingchang, Xi'an City 710065 (CN); Xie, Xiaoquiang, Xi'an City 710065 (CN)
(74) Representative: Høiberg P/S

(57) **Abstract**

The present disclosure provides a connection board for a flash memory chip, a preparation method therefor, and a flash memory chip, relating to the field of semiconductor technology. The connection board includes: an insulating layer (142), having a first surface and a second surface opposite to each other; a semiconductor substrate (143), disposed on the first surface of the insulating layer (142); and a conductive layer (141), disposed on the second surface of the insulating layer (142). The conductive layer (141) includes a plurality of conductive sheets of different shapes, and the conductive sheets are distributed at different positions on the second surface of the insulating layer (141), so that the pads (120) of the flash memory chip are coupled to external pins through the conductive sheets, thus reducing the proportion of bonding wires crossing the flash memory chip.

## Description

### TECHNICAL FIELD

The present disclosure relates to the field of semiconductor technology, and in particular to a connection board for a flash memory chip, a preparation method for the connection board, and a flash memory chip.

### BACKGROUND

In the field of semiconductor technology, static memory (such as a flash memory chip) plays a crucial role in recording and storing data, and is widely used in many industries such as computers, communications, consumer electronics, and automotive electronics, thus becoming one of the core components of modern technology. With the continuous development of technology, the packaging design of the flash memory chip is also constantly being optimized to improve performance and meet the ever-increasing application demands.

However, when the pads of the flash memory chip are designed to be located on a side of the lead frame, and signals are connected to external pins outside the lead frame through bonding wires, for example, when signals on the pads located on a side of the lead frame are connected to external pins on the other side of the lead frame through bonding wires, it typically requires to cross more than 90% of the length of the flash memory chip. This design results in excessively long arc lengths of bonding wires and relatively greater heights of bonding wires, increasing the risk of wire breakage or collapse during the packaging process. Simultaneously, this structure leads to an increase in overall package thickness, thus affecting compactness and reliability of the package.

How to reduce the proportion of bonding wires crossing the flash memory chip and reduce packaging risks is an urgent problem to be solved.

### SUMMARY

The present disclosure provides a connection board for a flash memory chip and a preparation method for the connection board, and a flash memory chip, where the proportion of crossing the flash memory chip is reduced to at least a certain extent, the wire arc is low, the packaging risk is low, and packaging thickness may also be reduced, thus improving packaging compactness and reliability.

Other features and advantages of the present disclosure will become apparent from the following detailed description, or may be learned in part from practice of the present disclosure.

According to an aspect of the present disclosure, there is provided a connection board for a flash memory chip, including: an insulating layer 142, having a first surface and a second surface opposite to each other; a semiconductor substrate 143, disposed on the first surface of the insulating layer 142; and a conductive layer 141, disposed on the second surface of the insulating layer 142, where the conductive layer 141 includes a plurality of conductive sheets of different shapes, the conductive sheets are distributed at different positions on the second surface of the insulating layer 142 to enable pads 120 of the flash memory chip 110 to be coupled to external pins 206 through the conductive sheets, thus reducing the proportion of bonding wires crossing the flash memory chip 110.

In an embodiment of the present disclosure, the insulating layer 142 includes a first insulating layer, and the first insulating layer is a high-polymer material layer or an oxide layer.

In an embodiment of the present disclosure, the insulating layer 142 includes: a first insulating layer, having a first surface and a second surface opposite to each other, where the second surface of the first insulating layer is the second surface of the insulating layer 142; and a second insulating layer, disposed on the first surface of the first insulating layer; where the first insulating layer is a high-polymer material layer, and the second insulating layer is an oxide layer.

In an embodiment of the present disclosure, the connection board 140 further includes a third insulating layer 144 disposed on the conductive layer 141, where the third insulating layer 144 is a high-polymer material layer.

In an embodiment of the present disclosure, a plurality of position marks 1416 are provided on the conductive sheets, the position marks 1416 are used to locate bonding wire positions to enable the conductive sheets to be coupled to the pads 120 of the flash memory chip 110 or the external pins 206 at the position marks 1416.

In an embodiment of the present disclosure, a width of a conductive sheet at the position marks 1416 is greater than a width of the conductive sheet at a position where the position marks 1416 are not marked.

In an embodiment of the present disclosure, the conductive sheets include one or more of an L-shaped conductive sheet 1411, a 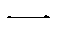 -shaped conductive sheet 1412, a 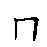 -shaped conductive sheet 1413, and a 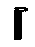 -shaped conductive sheet 1414.

In an embodiment of the present disclosure, the conductive sheets include an L-shaped conductive sheet 1411, a 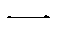 -shaped conductive sheet 1412, a 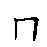 -shaped conductive sheet 1413, and a 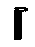 -shaped conductive sheet 1414. A plurality of L-shaped conductive sheets 1411 and a plurality of 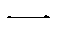 -shaped conductive sheets 1412 are located inside the 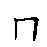 -shaped conductive sheet 1413, and a plurality of balance sheets 1415 distributed at intervals are provided at an opening of the 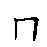 -shaped conductive sheet 1413.

In an embodiment of the present disclosure, the semiconductor substrate 143 is a bare silicon wafer or a bare wafer, and the bare silicon wafer is a P-type silicon wafer or an N-type silicon wafer.

According to another aspect of the present disclosure, there is further provided a flash memory chip, including a chip body and a connection board for the flash memory chip according to any of the above embodiments. The connection board 140 has a first surface and a second surface opposite to each other. The chip body is disposed on the first surface of the connection board 140. The connection board 140 is coupled to the chip body. The overall size of the connection board 140 is smaller than the overall size of the chip body.

In an embodiment of the present disclosure, the connection board 140 is located at the center of the chip body.

In an embodiment of the present disclosure, the connection board 140 further includes a first connection point group 201 and a second connection point group 202, where the first connection point group 201 and the second connection point group 202 are disposed on the second surface of the connection board 140 and distributed on two sides of the second surface of the connection board 140. Each of the first connection point group 201 and the second connection point group 202 includes a plurality of connection points 203, and the connection points 203 are coupled to the conductive layer 141 of the connection board 140. The chip body includes a plurality of pads 120, where the plurality of pads 120 are disposed on a side of a surface of the chip body closet to the first surface of the connection board 140. The distance from the plurality of pads 120 to the first connection point group 201 is less than the distance from the plurality of pads 120 to the second connection point group 202, M pads in the plurality of pads 120 are coupled to the connection points 203 in the first connection point group 201, and the connection points 203 in the first connection point group 201 are coupled to the connection points 203 in the second connection point group 202 through the conductive layer 141. The flash memory chip 110 further includes a first pin group 204 and a second pin group 205, the first pin group 204 and the second pin group 205 are distributed on two opposite sides of the chip body, and each of the first pin group 204 and the second pin group 205 includes a plurality of external pins 206. The distance of the first pin group 204 from the plurality of pads 120 is less than the distance of the second pin group 205 from the plurality of pads 120, K pads in the plurality of pads 120 are coupled to the external pins 206 in the first pin group 204, and the connection points 203 in the second connection point group 202 are coupled to the external pins 206 in the second pin group 205; where, M and K are both integers greater than or equal to 1, and the sum of M and K is less than or equal to the total number of the plurality of pads 120.

In an embodiment of the present disclosure, the plurality of external pins 206 and the plurality of pads 120 in the first pin group 204 are uniformly distributed in a 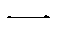 shape, and two pads 120 in the plurality of pads 120 located outside are respectively coupled to two external pins 206 in the first pin group 204 located outside. The plurality of external pins 206 in the first pin group 204 are in one-to-one correspondence with the K pads 120 in the plurality of pads 120 along the length direction of the chip body, and the bonding wire coupled between the pad 120 and the external pin 206 corresponding to each other in each group are parallel to the length direction of the chip body.

In an embodiment of the present disclosure, the connection board 140 further includes a plurality of connection points 203, the plurality of connection points 203 are disposed on the second surface of the connection board 140 and distributed on the outer edge of the connection board 140, and the connection points 203 are coupled to the conductive layer 141 of the connection board 140. The flash memory chip 110 further includes a first pin group 204 and a second pin group 205, the first pin group 204 and the second pin group 205 are distributed on two opposite sides of the chip body, and each of the first pin group 204 and the second pin group 205 includes a plurality of external pins 206. The chip body includes a plurality of pads 120, the plurality of pads 120 are disposed on a side of a surface of the chip body close to the first surface of the connection board 140, and the plurality of pads 120 are located between the first pin group 204 and the second pin group 205. T pads 120 in the plurality of pads 120 are coupled to a portion of the external pins 206 in the first pin group 204, E pads 120 in the plurality of pads 120 are coupled to a portion of the external pins 206 in the second pin group 205, and Q pads 120 in the plurality of pads 120 are coupled to the connection points 203, where, T, E, and Q are all integers greater than or equal to 1, and the sum of T, E, and Q is less than or equal to the total number of the plurality of pads 120.

According to another aspect of the present disclosure, there is further provided a preparation method for a connection board, including: providing a semiconductor substrate 143; forming an insulating layer 142 by coating an insulating layer solution on the semiconductor substrate 143 and performing curing treatment; and, forming a conductive layer 141 by coating photoresist on the insulating layer 142 and performing treatments of exposure, development, plating, photoresist removal and etching through a mask.

In an embodiment of the present disclosure, after forming the insulating layer 142 by coating the insulating layer solution on the semiconductor substrate 143 and performing curing treatment, the preparation method for the connection board further includes: forming a connection layer between the insulating layer 142 and the conductive layer 141, where the connection layer includes a first metal layer 1610 and a second metal layer 1620, the first metal layer 1610 is made of titanium, and the second metal layer 1620 is made of copper.

In an embodiment of the present disclosure, the conductive layer 141 includes a plurality of conductive sheets of different shapes; the conductive sheets include one or more of an L-shaped conductive sheet 1411, a 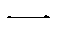 -shaped conductive sheet 1412, a 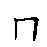 -shaped conductive sheet 1413 and a 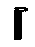 -shaped conductive sheet 1414; and the conductive sheets are copper sheets.

In embodiments of the present disclosure, the connection board for the flash memory chip includes an insulating layer, a semiconductor substrate, and a conductive layer. The insulating layer has a first surface and a second surface opposite to each other, the semiconductor substrate is disposed on the first surface of the insulating layer, and the conductive layer is disposed on the second surface of the insulating layer. The conductive layer includes a plurality of conductive sheets of different shapes distributed at different positions on the second surface of the insulating layer, so that the pads of the flash memory chip are coupled to external pins through the conductive sheets, thus reducing the proportion of the bonding wires crossing the flash memory chip. In the present disclosure, signals on the pads of the flash memory chip are connected to external pins through the conductive sheets of the conductive layer in the connection board, for example, signals on the pads located on a side of the lead frame are connected to external pins on the other side of the lead frame through the conductive sheets. Therefore, the length of the bonding wires used for coupling between the pads and external pins is reduced, the proportion of crossing the flash memory chip is reduced, the wire arc is low, and the packaging risk is low.

Furthermore, the conductive layer includes a plurality of conductive sheets of different shapes, and the conductive sheets are distributed at different positions on the second surface of the insulating layer. By using this arrangement, the pads of the flash memory chip may be coupled to external pins at any location through the conductive sheets of the connector board according to requirements, thus expanding the scope of application of the connection board. The risk of leakage of electricity at a high temperature may also be reduced due to the insulating layer.

Furthermore, in the present disclosure, the connection board formed by the insulating layer and the conductive layer provided on the semiconductor substrate has a small thickness, thus reducing the package thickness and improving the compactness and reliability of the package.

It should be understood that, the above general description and the following detailed description are exemplary and explanatory only, and are not intended to limit the present disclosure.

### BRIEF DESCRIPTION OF THE DRAWINGS

The accompanying drawings here, which are incorporated in and form part of the description, illustrate embodiments consistent with the present disclosure, and together with the description, serve to explain the principles of the present disclosure. It is obvious that the drawings described below are merely some embodiments of the present disclosure, and those skilled in the art may obtain other drawings based on these drawings without any inventive effort.
FIG. 1 shows a schematic diagram of a flash memory chip and positions of the pads.
FIG. 2 shows a schematic connection diagram of a flash memory chip provided according to an embodiment of the present disclosure.
FIG. 3 shows a schematic structural diagram of a connection board for a flash memory chip provided according to an embodiment of the present disclosure.
FIG. 4 shows a schematic structural diagram of a connection board for a flash memory chip provided according to another embodiment of the present disclosure.
FIG. 5 shows a schematic structural diagram of a connection board for a flash memory chip provided according to another embodiment of the present disclosure.
FIG. 6 shows a schematic structural diagram of a connection board for a flash memory chip provided according to another embodiment of the present disclosure.
FIG. 7 shows a schematic structural diagram of a connection board for a flash memory chip provided according to another embodiment of the present disclosure.
FIG. 8 shows a schematic structural diagram of a connection board for a flash memory chip provided according to another embodiment of the present disclosure.
FIG. 9 shows a schematic structural diagram of a connection board for a flash memory chip provided according to another embodiment of the present disclosure.
FIG. 10 shows a schematic structural diagram of a conductive layer provided according to an embodiment of the present disclosure.
FIG. 11 shows a schematic structural diagram of a conductive layer provided according to another embodiment of the present disclosure.
FIG. 12 shows a schematic structural diagram of a conductive layer provided according to another embodiment of the present disclosure.
FIG. 13 shows a schematic structural diagram of connection between a flash memory chip and a connection board provided according to an embodiment of the present disclosure.
FIG. 14 shows a schematic structural diagram of connection between a flash memory chip and a connection board provided according to an embodiment of the present disclosure.
FIG. 15 shows a flowchart of a preparation method for a connection board provided according to an embodiment of the present disclosure.
FIG. 16 shows a schematic diagram of a preparation process for a connection board provided according to an embodiment of the present disclosure.

Among them, the reference numerals in the accompanying drawings are explained as follows.

110, Flash memory chip; 120, Pad; 130, Lead frame; 140, Connection board; 141, Conductive layer; 1410, Copper layer; 1411, L-shaped conductive sheet; 1412, 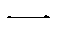 -shaped conductive sheet; 1413, 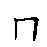 -shaped conductive sheet; 1414, 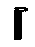 -shaped conductive sheet; 1415, Balance sheet; 1416, Position mark; 142, Insulating layer; 1421, Silicon oxide insulating layer; 1422, Polyimide layer; 143, Semiconductor substrate; 1431, Silicon substrate; 144, Third insulating layer; 201, First connection point group; 202, Second connection point group; 203, Connection point; 204, First pin group; 205, Second pin group; 206, External pin; 1610, First metal layer; 1620, Second metal layer; 1630, Photoresist layer; 1640, RDL layer.

### DETAILED DESCRIPTION

Preferred embodiments of the present disclosure will now be described in more detail with reference to the accompanying drawings. While preferred embodiments of the present disclosure are shown in the drawings, it should be understood that the present disclosure may be implemented in various forms and should not be limited to the embodiments set forth here. By contrast, these embodiments are provided so that the present disclosure will be thorough and complete, and will fully convey the scope of the present disclosure to those skilled in the art.

Terms of "first" and "second" used in this document are for descriptive purposes only and should not be construed as indicating or implying relative importance or implicitly specifying the number of indicated technical features. Therefore, a feature defined as "first" or "second" may explicitly or implicitly include one or more of the stated features. In the description of the present application, " a plurality of " means two or more, unless otherwise explicitly stated.

In the description of the present disclosure, it should be noted that, unless otherwise expressly specified and limited, the terms of "installation", "connection" and "linking" should be interpreted broadly. For example, they can refer to a fixed connection, a detachable connection, or an integral connection; they can refer to a mechanical connection, an electrical connection, or a connection that allows communication between them; they can refer to a direct connection or an indirect connection through an intermediate medium; they can refer to the internal communication between two components or the interaction between two components. Those skilled in the art can understand the specific meaning of the above terms in the present disclosure according to the specific circumstances.

The following disclosure provides many different implementations or examples for implementing different structures of the present disclosure. To simplify the present disclosure, specific examples of components and arrangements are described below. Of course, these are merely examples and are not intended to limit the scope of the present disclosure. Furthermore, reference numerals and/or reference letters may be repeated in different examples; such repetition is for simplification and clarity and does not in itself indicate a relationship between the various implementations and/or arrangements discussed.

As used in the present disclosure, the term "semiconductor substrate 143" refers to a material on which subsequent materials are added or otherwise disposed. Semiconductor substrate 143 may also be referred to as a core layer, the material disposed on semiconductor substrate 143 (e.g., the first surface and the second surface of semiconductor substrate 143) may be patterned or may remain not be patterned. Furthermore, semiconductor substrate 143 may be a silicon substrate 1431, a silicon-carbon substrate, a gallium nitride substrate, a gallium arsenide substrate, etc., and the material type of semiconductor substrate 143 may be determined according to the application scenario.

As used in the present disclosure, the term "layer" refers to a region of a material portion having a thickness, which may extend based on the entirety of the underlying or overlying structure, or may have a range smaller than a range of the underlying or overlying structure. Furthermore, a layer may be a region of a homogeneous or heterogeneous continuous structure with a thickness less than a thickness of a continuous structure. A layer may extend horizontally, vertically, and/ or along an inclined surface. Semiconductor substrate 143 may be a layer, which may include one or more layers, and/or may have one or more layers on, above, and/or below it. A layer may include a plurality of layers. For example, insulating layer 142 may include a first insulating layer and a second insulating layer.

As used here, a "connection board 140" has a plurality of vertically oriented material layers on a laterally oriented semiconductor substrate 143 such that the material layers extend in a vertical direction relative to the semiconductor substrate 143. As used here, the term "vertical/vertically" refers to a lateral surface being perpendicular to the semiconductor substrate 143.

As used here, the term "horizontal/horizontally/lateral/laterally" refers to a lateral surface being parallel to the semiconductor substrate 143, such as the opposite first surface or second surface of the insulating layer 142, i.e., the surface defined by the plane containing the first direction D1 and the second direction D2 in the drawings. The term "vertical" or "vertically" refers to a lateral surface being perpendicular to the insulating layer 142, such as along the direction represented by the third direction D3 in the drawings.

It should be noted that bonding wire refers to a type of metal wire used in the electronic packaging process to connect the flash memory chip 110 to external circuitry (such as the pins of the external circuitry, referred to as external pins 206). The bonding wire may be made of materials such as gold, silver, and aluminum, and has good conductivity and a high melting point to ensure a stable electrical connection during the operation of electronic devices.

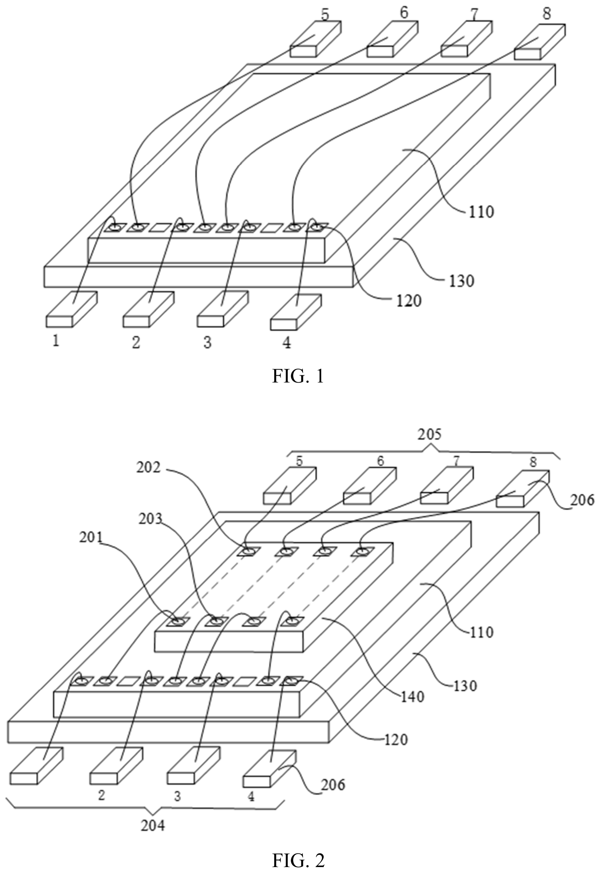

In the field of semiconductor technology, as shown in FIG. 1, when the pad 120 of the flash memory chip 110 is located on a side of the flash memory chip 110, and since the flash memory chip 110 is mounted on the lead frame 130, the pad 120 of the flash memory chip 110 is also located on a side of the lead frame 130. External pins 206 (pins 1, 2, 3, and 4) located on a side of the lead frame 130 are coupled to the pads 120 on the flash memory chip 110 through bonding wires. External pins 206 (pins 5, 6, 7, and 8) located on the other side of the lead frame 130 are also coupled to the pads 120 on the flash memory chip 110 through bonding wires. When these bonding wires connect signals to the external pins 206 (pins 5, 6, 7, and 8) on the other side of the lead frame 130, the bonding wires typically need to cross more than 90% of the entire length of the flash memory chip 110. This design results in excessively long arc lengths of bonding wires and relatively greater heights of bonding wires, increasing the risk of wire breakage or collapse during the packaging process. Simultaneously, this structure leads to an increase in the overall package thickness, thus affecting compactness and reliability of the package.

In related technologies, the above problem is solved by modifying the flash memory chip 110 to add pads 120, which increases the size of the flash memory chip 110 and leads to increased costs.

The connection board 140 in the present disclosure may be used to connect different chips or interconnection lines, and change the connection position of the pads 120, to enhance the packaging performance of the centralized circuit. As shown in FIG. 2, in the present disclosure, a connection board 140 is added on the flash memory chip 110 to replace the long bonding wires to connect the signals to the external pins 206 on the other side of the lead frame 130, thus reducing the proportion of crossing the flash memory chip 110.

In an embodiment, the connection board 140 is a substrate-type adapter board, which is manufactured by a laminating process. For example, the laminating process may be a tenting process or a modified semi-additive process (MSAP process).

The inventors discovered that, for the substrate-type adapter board manufactured through laminating process, the process is complex, and the size is large, which is not conducive to packaging. In the flash memory chip 110 with high-density interconnection requirements, it cannot meet the connection requirements of the high-performance flash memory chip 110 by using substrate-type adapter boards to change the position of pads 120.

To address the above issues, the present disclosure provides a connection board 140 for a flash memory chip 110. The connection board 140 includes: an insulating layer 142, having a first surface and a second surface opposite to each other; a semiconductor substrate 143, disposed on the first surface of the insulating layer 142; and, a conductive layer 141, disposed on the second surface of the insulating layer 142. The conductive layer 141 includes a plurality of conductive sheets of different shapes, and the conductive sheets are distributed at different positions on the second surface of the insulating layer 142, so that the pads 120 of the flash memory chip 110 are coupled to external pins 206 through the conductive sheets, thus reducing the proportion of bonding wires crossing the flash memory chip 110. In the present disclosure, not only the size requirements of the flash memory chip 110 may be satisfied, but also the requirements of high-density interconnection may be satisfied. Since the conductive layer 141 includes a plurality of conductive sheets and the conductive sheets are distributed at different positions on the insulating layer 142, the flash memory chip 110 can connect the signals on the pads 120 of the flash memory chip 110 to external pins 206 at different positions through the conductive sheets of the conductive layer 141 of the connection board 140 according to different needs. Moreover, the bonding wires coupled to the external pins 206 and the bonding wires coupled to the connection board 140 do not cross with each other, thus reducing coupling interference. This further improves the performance of the flash memory chip 110 on the premise of meeting the size requirements of the flash memory chip 110.

Furthermore, since the conductive layer 141 of the connection board 140 has a plurality of conductive sheets with different shapes and distribution positions, the scope of application of the connection board 140 may be extended. In other words, the connection board 140 may be used on different types of flash memory chips 110.

In the embodiments of the present disclosure, the thickness of the connection board 140 formed by providing an insulating layer 142 and a conductive layer 141 on the semiconductor substrate 143 is small, thus reducing the package thickness and improving the compactness and reliability of the package.

The present disclosure will now be described in detail with reference to the accompanying drawings and embodiments.

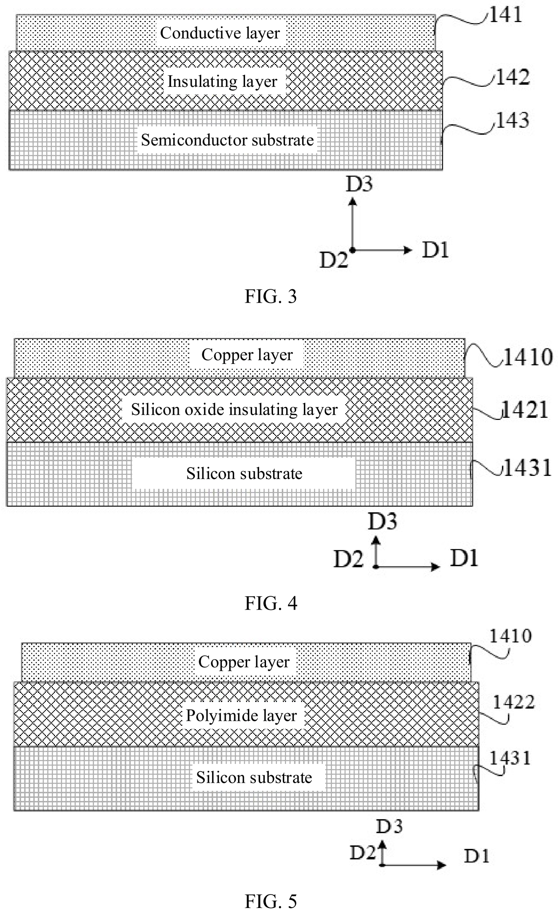

FIG. 3 shows a schematic structural diagram of a connection board for a flash memory chip provided in an embodiment of the present disclosure. As shown in FIG. 3, the connection board 140 of the flash memory chip 110 includes a conductive layer 141, an insulating layer 142, and a semiconductor substrate 143.

In the present disclosure, the first direction D1 is the long side direction of the connection board 140, the second direction D2 is the short side direction of the connection board 140, and the third direction D3 is the thickness direction of the connection board 140, where the first direction, the second direction, and the third direction are perpendicular to each other.

The insulating layer 142 has a first surface and a second surface opposite to each other. The first surface and the second surface are arranged along the third direction D3. The insulating layer 142 may be an oxide layer or a high-polymer material layer. For example, the oxide layer may be made of any one of silicon oxide (e.g., silicon dioxide), titanium oxide, aluminum oxide, zirconium oxide, copper oxide, and chromium oxide. The high-polymer material layer may be made of any one of polyethylene, polyvinyl chloride, polytetrafluoroethylene, and polyimide. It should be noted that the oxide layer is made of an oxide material, and the high-polymer layer is made of a high-polymer material.

The semiconductor substrate 143 is disposed on the first surface of the insulating layer 142. The semiconductor substrate 143 serves as a support portion of the connection board 140, for supporting other connection layers (such as the conductive layer 141 and the insulating layer 142). The shape of the semiconductor substrate 143 may be a rectangular block, the semiconductor substrate 143 may be made of any one of silicon, silicon-carbon, gallium nitride, and gallium arsenide, and the material type may be determined according to the application scenario. The semiconductor substrate 143 may be a bare silicon wafer or a bare wafer. The bare silicon wafer may be a P-type silicon wafer or an N-type silicon wafer. It should be noted that P-type silicon wafer is manufactured by doping silicon crystals with trivalent elements (such as boron), and the N-type silicon wafer is manufactured by doping silicon crystals with pentavalent elements (such as phosphorus).

The conductive layer 141 is disposed on the second surface of the insulating layer 142. The conductive layer 141 may include a plurality of conductive sheets of different shapes, which are distributed at different positions on the second surface of the insulating layer 142, so that the flash memory chip 110 is coupled to the conductive sheet from at least one direction of the connection board 140. It should be noted that there is a gap between any two adjacent conductive sheets.

The material of the conductive layer 141 may include one or more combinations of copper, silver, and gold. In the embodiments of the present disclosure, the conductive layer 141 may be a patterned circuit layer formed by performing etching according to actual needs.

It should be noted that, in order to increase the adhesion between the conductive layer 141 and the insulating layer 142, a first metal layer 1610 and a second metal layer 1620 may be sputtered (a semiconductor process) between the conductive layer 141 and the insulating layer 142. Among them, the first metal layer 1610 is made of titanium, and the second metal layer 1620 is made of copper. Exemplarily, the insulating layer 142, the first metal layer 1610, the second metal layer 1620, and the conductive layer 141 are distributed from bottom to top along the third direction D3.

It should be noted that, in the embodiment, the connection board 140 is fabricated by forming the insulating layer 142 and the conductive layer 141 on the semiconductor substrate 143 (such as a silicon wafer). That is, redistribution layers (RDL) are formed on the semiconductor substrate 143, and the insulating layer 142 and conductive layer 141 are the redistribution layers. Therefore, the thickness of the connection board 140 is very small. For example, the thickness of the connection board 140 is between 200 micrometers and 800 micrometers (0.2 millimeters to 0.8 millimeters), thus reducing the package thickness and improving the compactness and reliability of the package.

In the embodiments of the present disclosure, the connection board 140 not only meets the size requirements of the flash memory chip 110, but also meets the requirements of high-density interconnection. Since the conductive layer 141 includes a plurality of conductive sheets distributed at different positions on the insulating layer 142, the pads 120 of the flash memory chip 110 and external pins 206 may be connected to different conductive sheets or the same conductive sheet on the connection board 140 from different positions as needed, and the bonding wires used for connection do not cross with each other, thus reducing coupling interferences. This further improves the performance of the flash memory chip 110 on the precise of meeting the size requirements of the flash memory chip 110.

Furthermore, since the conductive layer 141 of the connection board 140 has a plurality of conductive sheets with different shapes and distribution positions, the scope of application of the connection board 140 may be extended. In other words, the connection board 140 may be used on different types of flash memory chips 110.

In the embodiments of the present disclosure, the thickness of the connection board 140 formed by providing an insulating layer 142 and a conductive layer 141 on the semiconductor substrate 143 is small, thus reducing the package thickness and improving the compactness and reliability of the package.

In the embodiments of the present disclosure, the flash memory chip 110 connects the signal to the external pin 206 on the other side of the lead frame 130 by replacing the long bonding wire with a connection board 140, which can may reduce the proportion of crossing the flash memory chip 110, resulting in a lower wire arc and a lower packaging risk.

In an example embodiment, the insulating layer 142 may include a first insulating layer, which is a high-polymer material layer or an oxide layer. For example, the first insulating layer is a polyimide layer 1422 or a silicon oxide insulating layer 1421.

In an embodiment, as shown in FIG. 4, the first insulating layer is a silicon oxide insulating layer 1421, the semiconductor substrate 143 is a silicon substrate 1431, and the conductive layer 141 is a copper layer 1410. The connection board 140 for the flash memory chip 110 provided in the embodiment may include a silicon substrate 1431, a silicon oxide insulating layer 1421, and a copper layer 1410 arranged from bottom to top along the third direction D3.

The connection board 140 in the embodiments of the present disclosure has a simple structure and is easy to manufacture. In the embodiments of the present disclosure, by connecting the connection board 140 to the flash memory chip 110, the proportion of crossing the flash memory chip 110 may be reduced, resulting in a lower wire arc and a lower packaging risk.

In another embodiment, as shown in FIG. 5, the first insulating layer is a polyimide layer 1422 (also known as a PI insulating layer). The semiconductor substrate 143 is a silicon substrate 1431, and the conductive layer 141 is a copper layer 1410. The connection board 140 for the flash memory chip 110 provided in the embodiments may include a silicon substrate 1431, a polyimide layer 1422, and a copper layer 1410 arranged from bottom to top along the third direction D3.

In the embodiments of the present disclosure, a polyimide layer 1422 is provided between the conductive layer 141 and the semiconductor substrate 143, thus solving the problem that there is a risk of leakage of electricity at a high temperature in the silicon oxide insulating layer 1421. By connecting the connector board 140 of the embodiments of the present disclosure to the flash memory chip 110, the proportion of crossing the flash memory chip 110 may be reduced, resulting in lower wire arc and lower packaging risk.

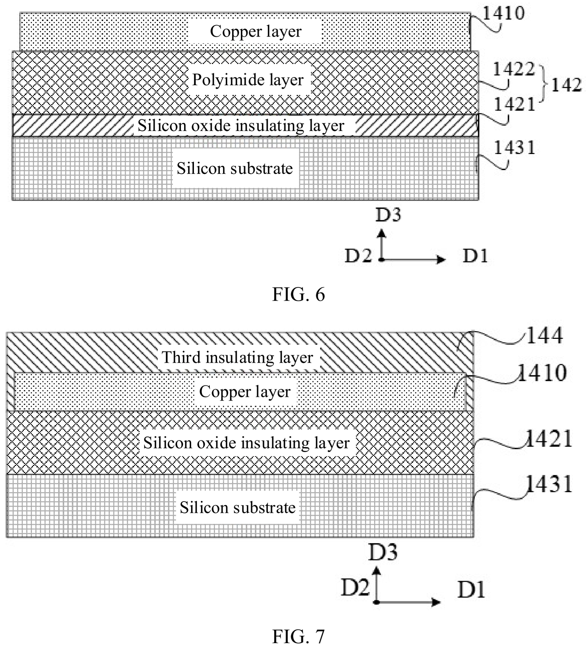

In another example embodiment, the insulating layer 142 may include a first insulating layer and a second insulating layer. The first insulating layer has a first surface and a second surface opposite to each other, and the second surface of the first insulating layer is the second surface of the insulating layer 142. The second insulating layer is disposed on the first surface of the first insulating layer, where the first insulating layer is a high-polymer material layer, and the second insulating layer is an oxide layer. For example, as shown in FIG. 6, the first insulating layer is a polyimide layer 1422, and the second insulating layer is a silicon oxide insulating layer 1421. An embodiment of the present disclosure provides a connection board 140 for a flash memory chip 110, and the connection board 140 may include a silicon substrate 1431, a silicon oxide insulating layer 1421, a polyimide layer 1422, and a copper layer 1410 arranged from bottom to top along a third direction D3.

In the embodiments of the present disclosure, a high-polymer material layer and an oxide layer are disposed between the conductive layer 141 and the semiconductor substrate 143, which may further enhance the insulation effect.

In the embodiments of the present disclosure, a polyimide layer 1422 and a silicon oxide insulating layer 1421 are disposed between the conductive layer 141 and the semiconductor substrate 143, which solves the problem that there is a risk of leakage of electricity at a high temperature in the silicon oxide insulating layer 1421. In the embodiments of the present disclosure, by connecting the connector board 140 to the flash memory chip 110, the proportion of crossing the flash memory chip 110 may be reduced, resulting in lower wire arc and lower packaging risk.

In yet another example embodiment, the connection board 140 may further include a third insulating layer 144 disposed on the conductive layer 141. That is, the third insulating layer 144 is disposed on a side surface of the conductive layer 141 away from the insulating layer 142. Among them, the third insulating layer 144 is a high-polymer material layer. For example, the third insulating layer 144 is a polyimide layer 1422.

In the embodiments of the present disclosure, a third insulating layer 144 is provided on the conductive layer 141 to prevent the conductive layer 141 from being exposed to the outside, thus solving the risk of short circuit caused by metallic foreign objects.

In the embodiments of the present disclosure, the third insulating layer 144 extends downward along the third direction D3 and fills between two adjacent conductive sheets on the conductive layer 141, thus further isolating the two adjacent conductive sheets, reducing the coupling effect between the conductive sheets, and further improving the working performance of the connection board 140 and the flash memory chip 110 using the connection board 140.

In an embodiment, as shown in FIG. 7, the connection board 140 may further include a third insulating layer 144, the semiconductor substrate 143 is a silicon substrate 1431, and the conductive layer 141 is a copper layer 1410. The connection board 140 for the flash memory chip 110 provided in the embodiments of the present disclosure may include a silicon substrate 1431, a silicon oxide insulating layer 1421, a copper layer 1410 and a third insulating layer 144 arranged from bottom to top along the third direction D3. Among them, the third insulating layer 144 may be a polyimide layer 1422, but the embodiments of the present disclosure are not limited to this.

In the embodiments of the present disclosure, the third insulating layer 144 is used to protect the conductive layer 141 and prevent the conductive layer 141 from being exposed outside, thus solving the problem of short circuit risk caused by foreign matter in the conductive layer 141.

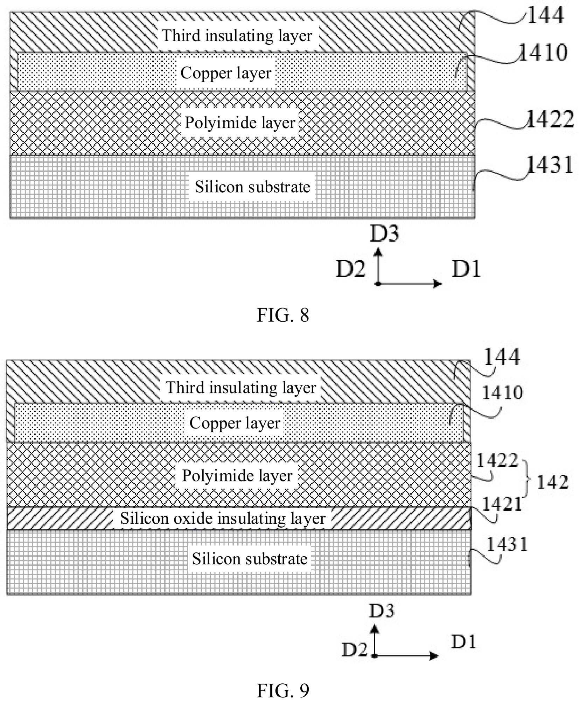

In another embodiment, as shown in FIG. 8, the connection board 140 may further include a third insulating layer 144, the semiconductor substrate 143 is a silicon substrate 1431, and the conductive layer 141 is a copper layer 1410. the connection board 140 of the flash memory chip 110 provided in this embodiment may include a silicon substrate 1431, a polyimide layer 1422, a copper layer 1410 and a third insulating layer 144 arranged from bottom to top along the third direction D3, where the third insulating layer 144 is a polyimide layer 1422, and the embodiments of the present disclosure are not limited to this.

The third insulating layer 144 in the embodiments is used to protect the conductive layer 141 and prevent the conductive layer 141 from being exposed outside, thus solving the problem of short circuit risk caused by foreign matter in the conductive layer 141. The polyimide layer 1422 located between the silicon substrate 1431 and the copper layer 1410 may effectively prevent the risk of leakage of electricity at a high temperature.

In another embodiment, as shown in FIG. 9, the connection board 140 may further include a third insulating layer 144, the semiconductor substrate 143 is a silicon substrate 1431, and the conductive layer 141 is a copper layer 1410. The connection board 140 for the flash memory chip 110 provided in the embodiments of the present disclosure may include a silicon substrate 1431, a silicon oxide insulating layer 1421, a polyimide layer 1422, a copper layer 1410 and a third insulating layer 144 arranged from bottom to top along the third direction D3, where the third insulating layer 144 is a polyimide layer 1422.

The third insulating layer 144 in the embodiments of the present disclosure is used to protect the conductive layer 141 and prevent the conductive layer 141 from being exposed outside, thus solving the problem of short circuit risk caused by foreign matter in the conductive layer 141. The polyimide layer 1422 located between the silicon substrate 1431 and the copper layer 1410 may effectively prevent the risk of leakage of electricity at a high temperature.

The lamination structure of the connection board 140 has been described above, and the conductive layer 141 of the connection board 140 will be described below through an example embodiment.

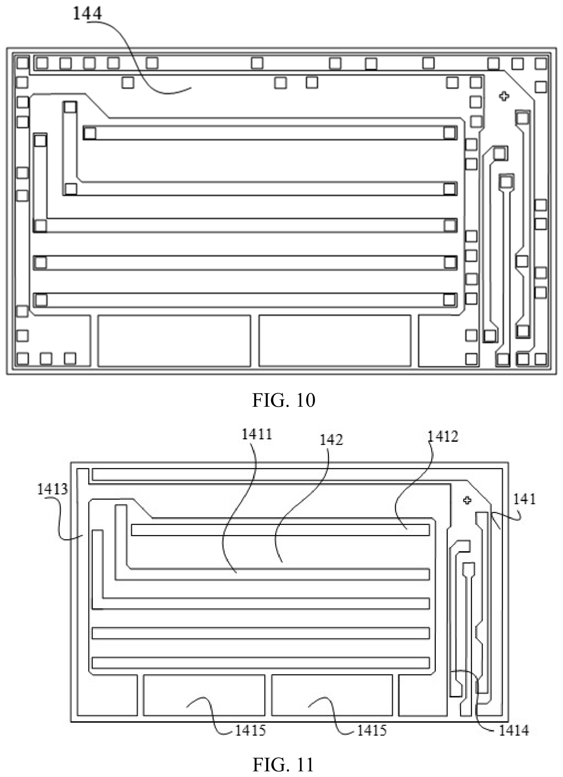

As shown in FIG. 10 to FIG. 12, the conductive layer 141 may include a plurality of conductive sheets of different shapes, and the conductive sheets are distributed at different positions on the second surface of the insulating layer 142. It should be noted that FIG. 10 to FIG. 12 are schematic diagrams illustrating the progressive improvements of the conductive layer 141 of the present disclosure.

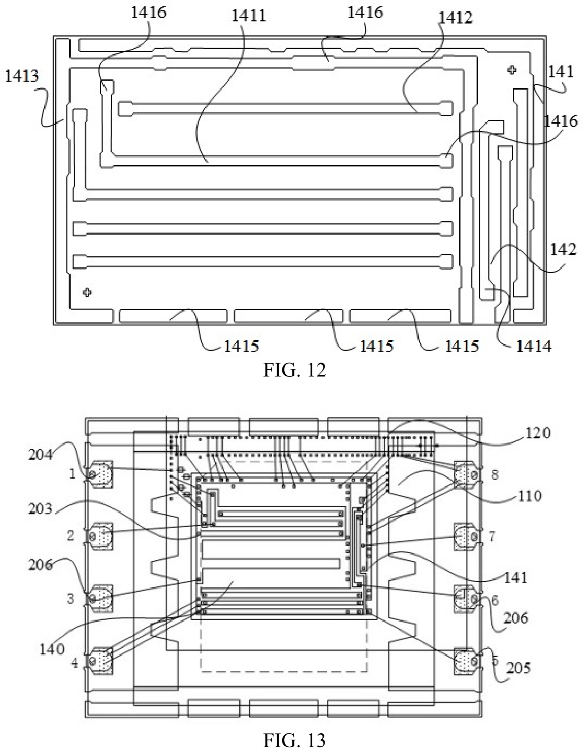

As shown in FIG. 10, the third insulating layer 144 covers the conductive layer 141 (not shown in FIG. 10 because it is covered). A window (the rectangular frame in FIG. 10) is made in the third insulating layer 144 to form a bonding wire Pad, which is then electroplated with NiAu (nickel-gold alloy) to complete the bonding wire Pad. It should be noted that the bonding wire Pad is located on the connector board 140, not the pad 120 on the flash memory chip 110. It should be noted that FIG. 10 is only a schematic diagram. The third insulating layer 144 covers the conductive layer 141. Since the conductive sheet is positioned high, it can be seen that the conductive sheet protrudes. Furthermore, the position of the conductive sheet may be determined based on the design dimensions of the conductive layer 141, thus determining the position of the window. To improve the insulation performance of the insulating layer 142 in the above embodiment at high temperatures and avoid leakage of electricity in high temperature, the structure of the conductive layer 141 as shown in FIG. 11 is provided. A polyimide layer 1422 and a silicon oxide insulating layer 1421 are disposed between the conductive layer 141 and the semiconductor substrate 143. The polyimide layer 1422 has excellent high-temperature resistance and excellent electrical insulation, thus improving the high-temperature insulation of the insulating layer 142 and eliminating leakage of electricity at a high temperature. To reduce metal coverage and accurately determine the bonding wire position, a conductive layer 141 as shown in FIG. 12 is provided.

In an example embodiment, as shown in FIG. 12, the conductive layer 141 may include a plurality of conductive sheets of different shapes, which are distributed at different positions on the second surface of the insulating layer 142. Among them, the conductive sheets are provided with a plurality of position marks 1416, which are used to locate the bonding wire positions so that the conductive sheets are coupled to the pads 120 of the flash memory chip 110 or external pins 206 at the position marks 1416.

For example, the width of the conductive sheet at the position mark 1416 is greater than the width of the conductive sheet at positions without the position mark 1416. By adding the position mark 1416, that is, specifically marking the bonding wire position, it facilitates the packaging wire bonding (WB) device to operate. After the position mark 1416 is added, the metal material coverage of the conductive layer 141 may be reduced while the requirements are met. Since the width of the conductive sheet at the position mark 1416 is greater than the width of the conductive sheet at other positions (where the position mark 1416 is not marked), the risk of warpage after the wafer is thinned may be reduced. It should be noted that this wafer may be the wafer used to fabricate the semiconductor substrate 143.

In an embodiment, as shown in FIG. 12, the conductive sheet may include one or more of an L-shaped conductive sheet 1411, a 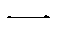 -shaped conductive sheet 1412, a 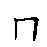 -shaped conductive sheet 1413, and a 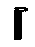 -shaped conductive sheet 1414. However, the embodiments of the present disclosure are not limited to these. The conductive sheets of the required shape may be designed according to the needs.

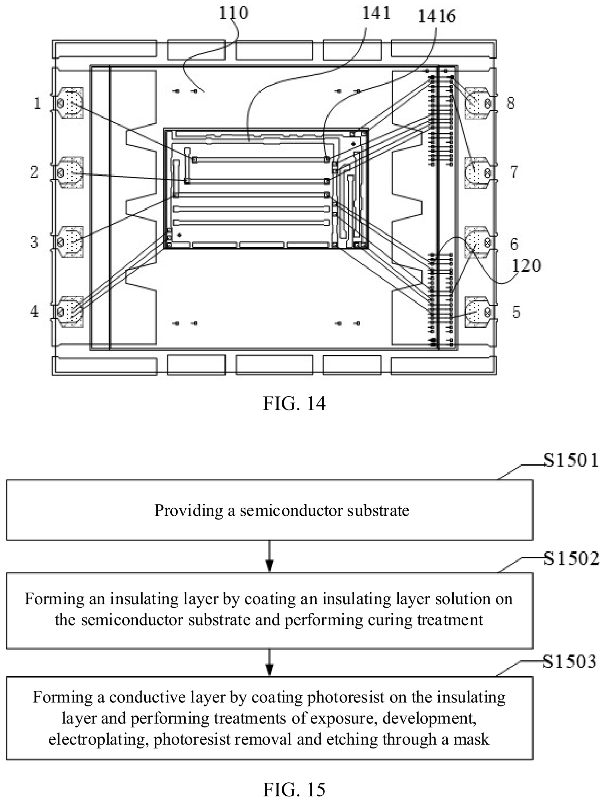

Among them, the --shaped conductive sheet 1412 parallel to the first direction D1 facilitates the coupling of the pads 120 on the flash memory chip 110 at one end of the 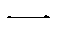 -shaped conductive sheet 1412 with the external pins 206 outside the flash memory chip 110/ lead frame 130 at the other end of the --shaped conductive sheet 1412 (referring to FIG. 14). It should be noted that the lead frame 130 is an indispensable part of the integrated circuit packaging process, and is responsible for connecting the flash memory chip 110 to the external circuit interface. For example, the flash memory chip 110 connects to the external circuit interface by connecting to the external pins 206. The --shaped conductive sheet 1412 may connect a plurality of bonding wires extending along the same direction (e.g., along the first direction D1) together, and may also connect a plurality of bonding wires extending along a plurality of directions together.

The 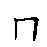 -shaped conductive sheet 1413 facilitates connecting a plurality of bonding wires located on the outer side of the 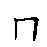 -shaped conductive sheet 1413 together. Similarly, the 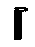 -shaped conductive sheet 1414 and the L-shaped conductive sheet 1411 may also connect a plurality of bonding wires together to achieve signal transmission, and there is no phenomenon that a plurality of bonding wires cross with each other, thus facilitating the packaging of the flash memory chip 110 while reducing interferences.

For example, as shown in FIG. 13, the connecting lines in FIG. 13 represent bonding wires. The bonding pads 120 on a side of the flash memory chip 110 may be connected to the external pins 206 at various positions through the conductive layer 141 of the connection board 140, preventing bonding wires from crossing with each other. It should be noted that the conductive layer 141 of the connection board 140 may also connect the bonding pads 120 on a side of the flash memory chip 110 to the required connection positions on the flash memory chip 110 (excepting the position where the connection board 140 overlaps with the flash memory chip 110), thus further preventing bonding wire crossing with each other.

In the embodiments of the present disclosure, a plurality of conductive sheets are distributed at different positions on the second surface of the insulating layer 142, thus minimizing the crossing between a plurality of bonding wires to the greatest extent possible, facilitating the subsequent packaging of the flash memory chip 110, reducing electromagnetic interference, and improving the performance of the flash memory chip 110.

In the embodiments of the present disclosure, the number of position marks 1416 is not limited and may be set according to the actual application scenario and specific application experience. For example, at least two position marks 1416 may be provided on each conductive sheet.

In the embodiments of the present disclosure, as shown in FIG. 14, a position mark 1416 is added to the conductive sheet, and the conductive sheet connects the signal located on a side of the flash memory chip 110 to the external pin 206 on the other side of the lead frame 130, thus reducing the proportion of crossing the flash memory chip 110, resulting in lower wire arc and lower packaging risk.

The present disclosure does not specifically limit the manner of adding the position mark 1416. For example, the RDL wiring may be specially designed to add the position mark 1416. The position mark 1416 is added to the layer structure on the mask for manufacturing the conductive layer 141, so that the manufactured conductive layer 141 also carries the position mark 1416. The position mark 1416 facilitates the packaging WB operation, thus improving the production efficiency and reducing the production cost.

It should be noted that during the bonding wire process, a bonding wire pad is made at the required position mark 1416 and then electroplated with NiAu. By plating with NiAu, good electrical properties, thermal stability and reliable mechanical adhesion may be provided.

In another embodiment, as shown in FIG. 12, the conductive sheet includes an L-shaped conductive sheet 1411, a --shaped conductive sheet 1412, a 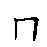 -shaped conductive sheet 1413, and a 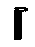 -shaped conductive sheet 1414. A plurality of L-shaped conductive sheets 1411 and a plurality of --shaped conductive sheets 1412 are located inside the 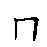 -shaped conductive sheet 1413, and a plurality of balance sheets 1415 distributed at intervals are provided at the opening of the 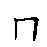 -shaped conductive sheet 1413.

In the embodiments of the present disclosure, the method for manufacturing the balance sheet 1415 is the same as that for manufacturing the conductive sheet, and the material of the balance sheet 1415 may also be the same as the material of the conductive sheet. The balance sheet 1415 is used to balance the conductive layer 141. For example, as shown in FIG. 12, when the 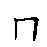 -shaped conductive sheet 1413 is large (for example, the 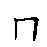 -shaped conductive sheet 1413 surrounds more than 70% of the area of the conductive layer 141), a plurality of balance sheets 1415 are provided at the opening of the 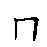 -shaped conductive sheet 1413 to support other layers (for example, the third insulating layer 144) located on the conductive layer 141 and distributed along the third direction D3 or the packaging shell for packaging the flash memory chip 110.

The conductive layer 141 has been described above, and the following describes how to performing the bonding wire Pad on the connector board 140.

In an embodiment, the connection board 140, which is shown in FIG. 7 and FIG. 10, is described. A third insulating layer 144 is provided to cover on the copper layer 1410. A window (the rectangular frame in FIG. 10) is made in the third insulating layer 144 to form a bonding wire pad which is then electroplated with NiAu to complete the bonding wire Pad. It should be noted that the position of the conductive sheet may be determined according to the design dimension drawing of the conductive layer 141, thus determining the position of the window.

To improve the insulation performance of the insulation layer 142 in the above embodiment at high temperatures and to avoid leakage of electricity at a high temperature, the next embodiment is provided.

In an embodiment, the connection board 140 combined with FIG. 6 and FIG. 11 will be described. A polyimide layer 1422 and a silicon oxide insulating layer 1421 are disposed between a copper layer 1410 and a silicon substrate 1431. The polyimide layer 1422 has excellent high temperature resistance and excellent electrical insulation, thus improving the high temperature insulation of the insulating layer 142 and eliminating the phenomenon of leakage of electricity at a high temperature.

In another embodiment, to prevent the copper layer 1410 from being exposed outside, a third insulating layer 144 is added based on FIG. 6, to form the connection board 140 structure shown in FIG. 9. A window (the rectangular frame in FIG. 10) is made in the third insulating layer 144 to create a bonding wire pad, which is then electroplated with NiAu, to complete the bonding wire Pad. The third insulating layer 144 is used to protect the copper layer 1410, and prevent the copper layer 1410 from being exposed outside, thus solving the problem of short-circuit risk caused by foreign matter in the conductive layer 141.

The connection board 140 produced by the above two embodiments may improve the high-temperature insulation of the insulation layer 142, and there is no phenomenon of leakage of electricity at a high temperature.

As shown in FIG. 11, since there is no bonding wire pad in the conductive layer 141, it is impossible for the WB device to accurately locate the bonding wire point (i.e., the bonding wire position) during the packaging process. To solve the problem of the conductive layer 141 in FIG. 11, the following embodiment is provided.

In an embodiment, the connection board 140 combined with FIG. 5 and FIG. 12 will be described. A position mark 1416 is added to the conductive sheet of the conductive layer 141. By adding the position mark 1416 as a special mark for the bonding wire position, it facilitates the packaging WB operation. After the position mark 1416 is added, the metal material coverage of the conductive layer 141 may be reduced while the requirements are met. Since the width of the conductive sheet at the position mark 1416 is greater than the width of the conductive sheet at other positions on the conductive sheet (where the position mark 1416 is not marked), the risk of warpage after the wafer is thinned may be reduced. It should be noted that this wafer may be the wafer used to fabricate the semiconductor substrate 143.

In the embodiments of the present disclosure, in order to avoid the conductive layer 141 to be exposed outside, a third insulating layer 144 may be added based on FIG. 5.

In another embodiment, the connection board 140 combined with FIG. 6 and FIG. 12 will be described. A position mark 1416 is added to the conductive sheet of the conductive layer 141. By adding the position mark 1416 as a special mark for the bonding wire position, it facilitates the packaging WB operation. After the position mark 1416 is added, the metal material coverage of the conductive layer 141 may be reduced while the requirements are met. Since the width of the conductive sheet at the position mark 1416 is greater than the width of the conductive sheet at other positions on the conductive sheet (where the position mark 1416 is not marked), the risk of warpage after the wafer is thinned may be reduced. It should be noted that this wafer may be the wafer used to fabricate the semiconductor substrate 143.

In the embodiments of the present disclosure, in order to avoid the conductive layer 141 to be exposed outside, a third insulating layer 144 may be added based on FIG. 6.

The connection board 140 manufactured in the above four embodiments may improve the high-temperature insulation of the insulation layer 142 and there is no phenomenon of leakage of electricity at a high temperature phenomenon.

It should be noted that the connection board 140 in the present disclosure is not limited to be applied to a static memory, but may also be applied to other chips.

Based on the same inventive concept, the present disclosure further provides a flash memory chip 110, which includes the connection board 140 described in the above embodiments, as shown in the following embodiments. Therefore, for the implementations of the embodiments of the flash memory chip 110, reference may be made to the implementations of the embodiments of the connection board 140 described above, and repeated details will not be described again.

The flash memory chip 110 provided by the present disclosure includes a chip body and a connection board 140 for the flash memory chip 110 in the above described embodiments. The connection board 140 has a first surface and a second surface opposite to each other. The chip body is disposed on the first surface of the connection board 140, and the connection board 140 is coupled to the chip body. The overall size of the connection board 140 is smaller than the overall size of the chip body. It should be noted that the chip body may be understood as a flash memory chip 110 excluding the connection board 140. Since the flash memory chip 110 in the related art do not include a connection board 140, the term "chip body" here refers to a flash memory chip 110 excluding the connection board 140.

In the embodiments of the preset disclosure, the overall size of the connection board 140 is smaller than the overall size of the chip body; that is, the length of the connection board 140 is less than the length of the chip body, and the width of the connection board 140 is less than the width of the chip body. It should be noted that the connection board 140 and the chip body are connected by bonding wires, thus facilitating signal transmission.

The position of the connection board 140 on the chip body is not limited in the embodiments of the present disclosure. Any position, where crossovers in the bonding wires used for connection is eliminated or is relatively less or (e.g., fewer than 5 crossovers) and the wire arc is lower, is acceptable. For example, the connection board 140 is located at the center of the chip body. As shown in FIG. 13 and FIG. 14, the connection board 140 is located at center of the chip body, so that the bonding wires converge towards the center, resulting in a lower wire arc, thus further reducing the size of the connection board 140, increasing the number of connection boards 140 fabricated on the same wafer, and reducing the production cost.

It should be noted that the geometric center of the connection board 140 and the geometric center of the flash memory chip 110 are distributed vertically along the third direction D3.

In an embodiment, the insulating layer 142 includes a first insulating layer, and the first insulating layer is a high-polymer material layer or an oxide layer.

In an embodiment, the insulating layer 142 includes: a first insulating layer, having a first surface and a second surface opposite to each other, where the second surface of the first insulating layer is the second surface of the insulating layer 142; and a second insulating layer, disposed on the first surface of the first insulating layer; where the first insulating layer is a high-polymer material layer and the second insulating layer is an oxide layer. For example, the first insulating layer is a polyimide layer 1422, and the second insulating layer is a silicon oxide insulating layer 1421.

In an embodiment, the connection board 140 further includes a third insulating layer 144 disposed on the conductive layer 141, where the third insulating layer 144 is a high-polymer material layer.

In an embodiment, a plurality of position marks 1416 are provided on the conductive sheets. The position marks 1416 are used to locate the bonding wire positions so that the conductive sheets are coupled to the pads 120 of the flash memory chip 110 or external pins 206 at the position marks 1416.

In an embodiment, the width of the conductive sheet at the position mark 1416 is greater than the width of the conductive sheet at a position where the position mark 1416 is not marked.

In an embodiment, the conductive sheets include one or more of the following: an L-shaped conductive sheet 1411, a 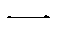 -shaped conductive sheet 1412, a 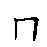 -shaped conductive sheet 1413, and a 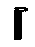 -shaped conductive sheet 1414.

In an embodiment, the conductive sheets include an L-shaped conductive sheet 1411, a 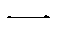 -shaped conductive sheet 1412, a 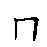 -shaped conductive sheet 1413, and a 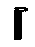 -shaped conductive sheet 1414. A plurality of L-shaped conductive sheets 1411 and a plurality of 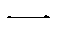 -shaped conductive sheets 1412 are located inside the 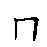 -shaped conductive sheet 1413, and a plurality of balance sheets 1415 distributed at intervals are provided at an opening of the 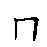 -shaped conductive sheet 1413.

In an embodiment, the semiconductor substrate 143 is a bare silicon wafer or a bare wafer, which may be a P-type silicon wafer or an N-type silicon wafer.

In an embodiment, the connection board 140 may further include a first connection point group 201 and a second connection point group 202. The first connection point group 201 and the second connection point group 202 are disposed on the second surface of the connection board 140 and distributed on two sides of the second surface of the connection board 140. Each of the first connection point group 201 and the second connection point group 202 includes a plurality of connection points 203, and the connection points 203 are coupled to the conductive layer 141 of the connection board 140. It should be noted that in some embodiments, the connection points 203 are coupled to the position marks 1416 of the conductive sheets of the conductive layer 141. The chip body includes a plurality of pads 120, and the plurality of pads 120 are disposed on a side of a surface of the chip body close to the first surface of the connection board 140. The distance from the plurality of pads 120 to the first connection point group 201 is less than the distance from the plurality of pads 120 to the second connection point group 202. M pads 120 in the plurality of pads are coupled to the connection points 203 in the first connection point group 201. Connection points 203 in the first connection point group 201 are coupled to connection points 203 in the second connection point group 202 through the conductive layer 141. The flash memory chip 110 further includes a first pin group 204 and a second pin group 205. The first pin group 204 and the second pin group 205 are distributed on two opposite sides of the chip body. Each of the first pin group 204 and the second pin group 205 includes a plurality of external pins 206. The distance from the first pin group 204 to the plurality of pads 120 is less than the distance from the second pin group 205 to the plurality of pads 120. K pads 120 in the plurality of pads 120 are coupled to the external pins 206 in the first pin group 204. Connection points 203 in the second connection point group 202 are coupled to the external pins 206 in the second pin group 205. Among them, M and K are both integers greater than or equal to 1, and the sum of M and K is less than or equal to the total number of the plurality of pads 120.

In the embodiments of the present disclosure, the value of M and the value K are not specifically limited, but may be determined adaptively as needed.

For example, as shown in FIG. 2, M=4, K= 4, and there are 10 pads 120 on the chip body. A first connection point group 201 and a second connection point group 202 are provided on the second surface (e.g., the top surface) of the connection board 140. The first connection point group 201 and the second connection point group 202 are distributed on two sides of the second surface of the connection board 140. That is, the first connection point group 201 and the second connection point group 202 are distributed on both sides of the top surface of the connection board 140. Each of the first connection point group 201 and the second connection point group 202 includes a plurality of connection points 203. A plurality of pads 120 are disposed on a side of a surface of the chip body close to the first surface of the connection board 140. The distance from the plurality of pads 120 to the first connection point group 201 is less than the distance from the plurality of pads 120 to the second connection point group 202. Four pads in the plurality of pads 120 are coupled to the connection points 203 in the first connection point group 201. The connection points 203 in the first connection point group 201 are coupled to the connection points 203 in the second connection point group 202 through the conductive layer 141. It should be noted that the connection points 203 in the first connection point group 201 are coupled to the connection points 203 in the second connection point group 202 through the conductive sheet in the conductive layer 141. The flash memory chip 110 further includes a first pin group 204 (pin 1, pin 2, pin 3, pin 4) and a second pin group 205 (pin 5, pin 6, pin 7, pin 8). The first pin group 204 and the second pin group 205 are distributed on two opposite sides of the chip body. Each of the first pin group 204 and the second pin group 205 includes a plurality of external pins 206. The distance from the first pin group 204 to the plurality of pads 120 is less than the distance from the second pin group 205 to the plurality of pads 120. Four pads in the plurality of pads 120 are coupled to the external pins 206 in the first pin group 204. The connection points 203 in the second connection point group 202 are coupled to the external pins 206 in the second pin group 205. The plurality of pads 120 are coupled to the external pins 206 in the second pin group 205, which are located at a greater distance, through the connection board 140, thus crossing the flash memory chip 110. This reduces the proportion of crossing the flash memory chip 110, resulting in a lower wire arc and lower packaging risk. In addition, the connection board 140 has a heat dissipation function, which may accelerate the heat dissipation of the flash memory chip 110 and ensure the working performance of the flash memory chip 110.

It should be noted that connection point 203 is a point connected to the conductive sheet in the conductive layer 141 (such as the bonding wire Pad at the bonding wire position mentioned above).

To increase the packaging strength of the flash memory chip 110, the flash memory chip 110 may further include a lead frame 130 for mounting the chip body. The chip body is disposed on the lead frame 130, and the lead frame 130 supports the chip body, thus increasing the mechanical strength of the flash memory chip 110 and reducing the probability of damage to the flash memory chip 110. In the embodiments of the present disclosure, signals may be connected to external pins 206 outside the lead frame 130 through a connection board 140, reducing the proportion of crossing the flash memory chip 110, and resulting in lower wire arc and lower packaging risk.

To further reduce the packaging risk, as shown in FIG. 2, a plurality of external pins 206 in the first pin group 204 and a plurality of pads 120 are uniformly distributed in a 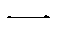 shape. Two pads 120 in the plurality of pads 120 located outside are coupled to two external pins 206 in the first pin group 204 located outside. The plurality of external pins 206 in the first pin group 204 are in one-to-one correspondence with K (e.g., K=4 in FIG. 2, but the embodiments of the present disclosure are not limited to this) pads 120 in the plurality of pads 120 along the length direction of the chip body (e.g., the first direction D1). The bonding wire coupled between the pad 120 and the external pin 206 corresponding to each other in each group is parallel to the length direction of the chip body. It should be noted that the plurality of external pins 206 in the first pin group 204 align with their corresponding pads 120 along the length direction of the chip body, therefore, not only the length of the bonding wires used for coupling between the plurality of external pins 206 in the first pin group 204 and their corresponding pads 120 may be reduced, thus saving the production cost, but also the packaging risk may be reduced.

The above example embodiments are one implementation of the present disclosure, and the embodiments of the present disclosure are not limited to this. For example, another implementation of the present disclosure is shown in FIG. 13. A plurality of pads 120 on the chip body are located on a side of the chip body. The bonding wires on the pads 120 may be coupled to the external pins 206 (pin 1, pin 2, pin 3, pin 4, pin 5, pin 6, pin 7 and pin 8) distributed on both sides of the pads 120 through the connection board 140.

In an embodiment, the connection board 140 may further include a plurality of connection points 203 disposed on the second surface of the connection board 140 and distributed on the outer edge of the connection board 140. The connection points 203 are coupled to the conductive layer 141 of the connection board 140. It should be noted that in some embodiments, the connection points 203 are located at the position marks 1416 of the conductive sheets of the conductive layer 141. As shown in FIG 13, the connection points 203 are distributed on the outer edge of the connection board 140, which is beneficial for connecting to external pins 206, thus reducing the proportion of crossing the flash memory chip 110 when the pads 120 are connected to the external pins 206, resulting in lower wire arc and lower packaging risk.

The flash memory chip 110 further includes a first pin group 204 and a second pin group 205, which are distributed on two opposite sides of the chip body. Each of the first pin group 204 and the second pin group 205 includes a plurality of external pins 206.

The chip body includes a plurality of pads 120, which are disposed on a side of a surface of the chip body close to the first surface of the connection board 140. The plurality of pads 120 are located between the first pin group 204 and the second pin group 205. T pads 120 in the plurality of pads 120 are coupled to some external pins 206 in the first pin group 204. E pads 120 in the plurality of pads 120 are coupled to some external pins 206 in the second pin group 205. Q pads 120 in the plurality of pads 120 are coupled to connection points 203. Among them, T, E, and Q are all integers greater than or equal to 1, and the sum of T, E, and Q is less than or equal to the total number of the plurality of pads 120.

In the embodiments, the values of T, E, and Q are not limited, which may be set according to the actual application scenario and specific application experience.

In the embodiments of the present disclosure, a connection board 140 is added onto the chip body to connect signals, resulting in a lower proportion of bonding wire crossing the flash memory chip 110, a lower wire arc, and a lower packaging risk.

Based on the same inventive concept, the present disclosure further provides a preparation method for a connection board 140, as described in the following embodiments. Therefore, for the implementation of the preparation method embodiments, reference may be made to the implementation of the connection board 140 embodiments described above, and repeated details will not be repeated.

FIG. 15 shows a flowchart of a preparation method for a connection board according to an embodiment of the present disclosure. As shown in FIG. 15, the preparation method for a connection board 140 provided by the present disclosure may include the following steps S1501 to S1503.

In S1501, a semiconductor substrate 143 is provided.

In the embodiments of the present disclosure, the semiconductor substrate 143 may be any one of the following: a silicon substrate 1431, a silicon-carbon substrate, a gallium nitride substrate, or a gallium arsenide substrate. The material type of the semiconductor substrate 143 may be determined according to the application scenario.

For example, the semiconductor substrate 143 may be a bare silicon wafer or a bare wafer, and the bare silicon wafer may be a P-type silicon wafer or an N-type silicon wafer.

In S1502, an insulating layer 142 is formed by coating an insulating layer solution on the semiconductor substrate 143 and performing curing treatment.

In the embodiments of the present disclosure, the insulating layer solution is the solution used to form the insulating layer 142. The specific type of solution is not limited in the embodiments of the present disclosure. For example, the insulating layer solution may be a polyimide (PI) solution.

In S1503, a conductive layer 141 is formed by coating photoresist on insulating layer 142, and performing treatments of exposure, development, plating, photoresist removal and etching through a mask through a mask.

In an embodiment, after forming the insulating layer 142 by coating the insulating layer solution on the semiconductor substrate 143 and performing curing treatment (i.e., S1502), the preparation method for the connection board 140 further includes: forming a connection layer between the insulating layer 142 and the conductive layer 141, where the connection layer includes a first metal layer 1610 and a second metal layer 1620, the first metal layer 1610 is made of titanium, and the second metal layer 1620 is made of copper.

For example, the connection layer may be formed by sputtering a first metal layer 1610 and a second metal layer 1620 onto the insulating layer 142. The conductive layer 141 may be formed by coating photoresist on the connection layer and performing treatments of exposure, development, plating, photoresist removal and etching through a mask.

In the embodiments of the present disclosure, by sputtering a first metal layer 1610 and a second metal layer 1620 onto the insulating layer 142, the adhesion between the insulating layer 142 and the conductive layer 141 fabricated in subsequent processes may be increased. Good adhesion between the insulating layer 142 and the conductive layer 141 helps ensure the stability of the electrical connection, thus avoiding poor electrical contact due to poor adhesion, and further improving the conductivity and reliability of the circuit. Good adhesion between the insulating layer 142 and the conductive layer 141 also effectively prevents interlayer separation caused by mechanical stress or differences in thermal expansion, thus extending the service life of the connection board 140.

Among them, the conductive layer 141 may include a plurality of conductive sheets of different shapes. The conductive sheets may include one or more of an L-shaped conductive sheet 1411, a 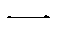 -shaped conductive sheet 1412, a 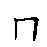 -shaped conductive sheet 1413, and a 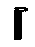 -shaped conductive sheet 1414. The conductive sheets are copper sheets.

It should be noted that the mask is the mask corresponding to the conductive layer 141 on the connection board 140 in the embodiments of the present disclosure. Through the mask and subsequent processes, the conductive layer 141 including a plurality of conductive sheets of different shapes in the embodiments of the present disclosure may be formed.

In the embodiments of the present disclosure, in order to further increase the adhesion between the insulating layer 142 and the conductive layer 141, the material of the second metal layer 1620, which is bonded to the conductive layer 141, is the same as the material of the conductive layer 141. For example, the material of the second metal layer 1620 is copper, and the material of the conductive layer 141 is also copper, thus increasing the adhesion between the insulating layer 142 and the conductive layer 141.

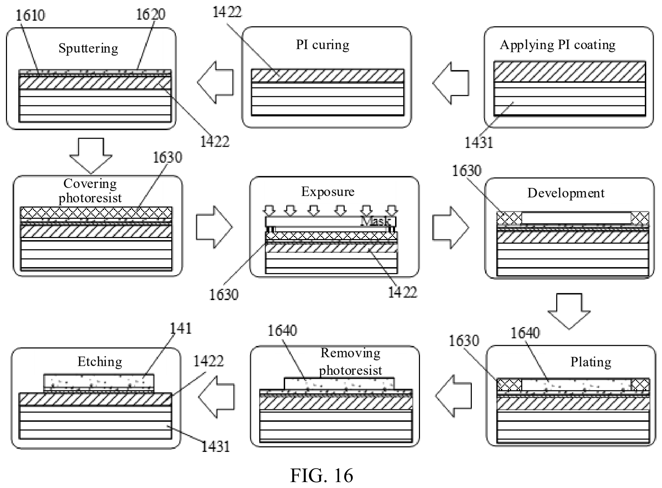

For example, as shown in FIG. 16, the preparation process of the connection board 140 may include the following steps A1 to A9.

In step A1, a polyimide (PI) solution is coated onto the silicon substrate 1431 to form a PI coating.

In the embodiments of the present disclosure, a PI solution is coated on the silicon substrate 1431 to prepare a polyimide coating, thus improving the high-temperature insulation of the connection board 140 and solving the problem of leakage of electricity at a high temperature.

It should be noted that the silicon substrate 1431 may be covered with a silicon dioxide insulating layer 1421, or may not be covered with a silicon dioxide insulating layer 1421.

In step A2, the PI coating is cured to form a polyimide layer 1422.

In the embodiments of the present disclosure, curing the PI coating is beneficial to enhancing the stability of the polyimide layer 1422.

In step A3, sputtering treatment is performed on the polyimide layer 1422 to form a first metal layer 1610 and a second metal layer 1620 (i.e., a connection layer) sequentially. The connection layer is used to improve the adhesion between the polyimide layer 1422 and the conductive layer 141 to be prepared.

In the embodiments of the present disclosure, the first metal layer 1610 may be made of titanium, and the second metal layer 1620 is made of the same material as the conductive layer 141, and the second metal layer 1620 may be made of copper.

Is step A4, a layer of photoresist (PR) is spin-coated (covered) onto the second metal layer 1620 to form a photoresist layer 1630.

In step A5, exposure treatment is performed on the photoresist layer 1630 using a mask.

In step A6, development treatment is performed on the exposed photoresist layer 1630 using a developer.

In the embodiments of the present disclosure, during the development process, a groove structure that matches the shape of the conductive layer 141 may be formed on the photoresist layer 1630 according to the exposure pattern. The principle of this process is based on the selective exposure and development of the photoresist in the photolithography process. The development treatment is performed on the exposed photoresist, in which the unexposed portions of the photoresist are removed and the groove corresponding to the pattern is left. The shape of the groove precisely matches the structure of the conductive layer 141, forming a template suitable for subsequent metal plating.

In step A7, plating treatment is performed on the photoresist layer 1630 after the development treatment to form the RDL layer 1640.

In the embodiments of the present disclosure, metal plating may be performed within the groove to form a conductive layer 141 connected to the second metal layer 1620. In this way, metal may be precisely deposited into specific areas (e.g., areas forming conductive sheets), ensuring adhesion between the conductive layer 141 and the second metal layer 1620, while reducing unnecessary metal waste and forming precise conductive channels.

It should be noted that the metal used for plating may be any of copper, nickel, and gold.

In step A8, the photoresist on the RDL layer 1640 is removed.

In step A9, etching is performed on the first metal layer 1610 and the second metal layer 1620 surrounding the RDL layer 1640 until the polyimide layer 1422 is reached, and then etching is stopped, thus completing the preparation of the conductive layer 141.

In the embodiments of the present disclosure, the first metal layer 1610 and the second metal layer 1620 surrounding the RDL layer 1640 are etched to precisely remove excess metal layers until the polyimide layer 1422 is reached, thus completing the pattern definition of the conductive layer 141. The principle is based on a selective etching process. For example, the conductive layer 141 includes a plurality of conductive sheets of different shapes, and the conductive sheets may include one or more of an L-shaped conductive sheet 1411, a 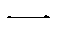 -shaped conductive sheet 1412, a 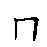 -shaped conductive sheet 1413, and a 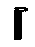 -shaped conductive sheet 1414, where a plurality of position marks 1416 are provided on the conductive sheets. The width of the conductive sheet at the position mark 1416 is greater than the width at other positions on the conductive sheet. Therefore, the risk of warpage of the conductive sheet may be reduced, which may facilitates reducing the width of the conductive sheet and reducing metal coverage, and thus reducing the production cost. The conductive layer 141 may further include a plurality of balance sheets 1415.

In an embodiment, etching technology is used to remove the metal layer through chemical reaction or physical action. The depth and extent of etching are precisely adjusted by controlling the etching time and selection of the chemical agent. To ensure that etching only affects the metal layer without damage to the underlying polyimide layer 1422, a relatively mild etching condition or a staged etching process is used in the embodiments of the present disclosure. The polyimide layer 1422, as a high-temperature resistant and chemically resistant insulating material layer, is designed as an etching stop layer. That is, once etching reaches the polyimide layer 1422, the etching process stops, thus protecting the underlying structure (such as the silicon substrate 1431) from damage. Through this etching method, the shape and size of the conductive layer 141 may be precisely controlled, providing the necessary circuit patterns and connection structures for subsequent process steps (such as interconnection, packaging, etc.), thus completing the preparation of the conductive layer 141 and ensuring the electrical performance and structural stability of the conductive layer 141.

In the embodiments of the present disclosure, the connection board 140 formed by the above-described preparation method has good electrical performance and structural stability.

In the embodiments of the present disclosure, the terms "first", "second", and "third" are used for descriptive purposes only and should not be construed as indicating or implying relative importance. The term "a plurality of" refers to two or more unless otherwise expressly defined. The terms "installation", "connection", "link" and "fixation" should be interpreted broadly. For example, "connection" may be a fixed connection, a detachable connection, or an integral connection. "Connection " may be a direct connection or an indirect connection through an intermediate medium. Those skilled in the art may understand the specific meaning of the above terms in the embodiments of the present disclosure based on the specific circumstances.

In the description of the embodiments of the present application, it should be understood that the orientation or positional relationship indicated by terms "upper", "lower", "left", "right", "front", "rear", etc., is based on the orientation or positional relationship shown in the accompanying drawings, which is only for the convenience of describing the embodiments of the application and simplifying the description, and does not indicate or imply that the apparatus or unit referred to must have a specific orientation or be constructed and operated in a specific orientation. Therefore, it should not be construed as a limitation on the embodiments of the present application.

In the description of this specification, description of the terms "an embodiment", "some embodiments", "specific embodiment", etc., refer to that a specific feature, structure, material, or characteristic described in connection with that embodiment or example is included in at least an embodiment or example of the present application. In this specification, the illustrative expressions of the above terms do not necessarily refer to the same embodiment or example. Furthermore, the specific feature, structure, material, or characteristic described may be combined in any suitable manner in one or more embodiments or examples.

The above are merely preferred embodiments of the embodiments of the present application and are not intended to limit the embodiments of the present application. For those skilled in the art, the embodiments of the present application may have various modifications and variations. Any modifications, equivalent substitutions, improvements, etc., made within the spirit and principles of the embodiments of the present application should be included within the protection scope of the embodiments of the present application.

## Claims

1. A connection board for a flash memory chip, comprising:
an insulating layer (142), having a first surface and a second surface opposite to each other;
a semiconductor substrate (143), disposed on the first surface of the insulating layer (142); and
a conductive layer (141), disposed on the second surface of the insulating layer (142), wherein the conductive layer (141) comprises a plurality of conductive sheets of different shapes, the conductive sheets are distributed at different positions on the second surface of the insulating layer (142) to enable pads (120) of the flash memory chip (110) to be coupled to external pins (206) through the conductive sheets, to reduce a proportion of bonding wires crossing the flash memory chip (110).

2. The connection board according to claim 1, wherein the insulating layer (142) comprises a first insulating layer, and the first insulating layer is a high-polymer material layer or an oxide layer;
or,
the insulating layer (142) comprises:
a first insulating layer, having a first surface and a second surface opposite to each other, wherein the second surface of the first insulating layer is the second surface of the insulating layer (142); and
a second insulating layer, disposed on the first surface of the first insulating layer;
wherein the first insulating layer is a high-polymer material layer, and the second insulating layer is an oxide layer.

3. The connection board according to claim 2, wherein the connection board (140) further comprises:
a third insulating layer (144), disposed on the conductive layer (141), wherein the third insulating layer (144) is a high-polymer material layer.

4. The connection board according to claim 1, wherein a plurality of position marks (1416) are provided on the conductive sheets, the position marks (1416) are used to locate bonding wire positions to enable the conductive sheets to be coupled to the pads (120) of the flash memory chip (110) or the external pins (206) at the position marks (1416).

5. The connection board according to claim 4, wherein a width of a conductive sheet at the position marks (1416) is greater than a width of the conductive sheet at a position where the position marks (1416) are not marked.

6. The connection board according to claim 1, wherein the conductive sheets comprise one or more of an L-shaped conductive sheet (1411), a 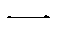 -shaped conductive sheet (1412), a 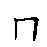 -shaped conductive sheet (1413), and a 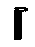 -shaped conductive sheet (1414);
or,
the conductive sheets comprises an L-shaped conductive sheet (1411), a 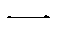 -shaped conductive sheet (1412), a 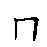 -shaped conductive sheet (1413), and a 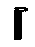 -shaped conductive sheet (1414); a plurality of L-shaped conductive sheets (1411) and a plurality of --shaped conductive sheets (1412) are located inside the 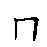 -shaped conductive sheet (1413); and a plurality of balance sheets (1415) distributed at intervals are provided at an opening of the 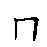 -shaped conductive sheet (1413).

7. The connection board according to claim 1, wherein the semiconductor substrate (143) is a bare silicon wafer or a bare wafer, and the bare silicon wafer is a P-type silicon wafer or an N-type silicon wafer.

8. A flash memory chip, comprising a chip body and a connection board for the flash memory chip according to any one of claims 1 to 7, wherein the connection board (140) has a first surface and a second surface opposite to each other, the chip body is disposed on the first surface of the connection board (140), the connection board (140) is coupled to the chip body, and an overall size of the connection board (140) is smaller than an overall size of the chip body.

9. The flash memory chip according to claim 8, wherein the connection board (140) is located at a center of the chip body.

10. The flash memory chip according to claim 8, wherein the connection board (140) further comprises a first connection point group (201) and a second connection point group (202), the first connection point group (201) and the second connection point group (202) are disposed on the second surface of the connection board (140) and distributed on two sides of the second surface of the connection board (140), each of the first connection point group (201) and the second connection point group (202) comprises a plurality of connection points (203), the connection points (203) are coupled to the conductive layer (141) of the connection board (140);
the chip body comprises a plurality of pads (120), the plurality of pads (120) are disposed on a side of a surface of the chip body close to the first surface of the connection board (140), a distance from the plurality of pads (120) to the first connection point group (201) is less than a distance from the plurality of pads (120) to the second connection point group (202), M pads (120) in the plurality of pads (120) are coupled to the connection points (203) in the first connection point group (201), the connection points (203) in the first connection point group (201) are coupled to the connection points (203) in the second connection point group (202) through the conductive layer (141); and
the flash memory chip (110) further comprises a first pin group (204) and a second pin group (205), wherein the first pin group (204) and the second pin group (205) are distributed on two opposite sides of the chip body, each of the first pin group (204) and the second pin group (205) comprises a plurality of external pins (206), a distance from the first pin group (204) to the plurality of pads (120) is less than a distance from the second pin group (205) to the plurality of pads (120), K pads (120) in the plurality of pads (120) are coupled to the external pins (206) in the first pin group (204), and the connection points (203) in the second connection point group (202) are coupled to the external pins (206) in the second pin group (205);
wherein M and K are both integers greater than or equal to 1, and a sum of M and K is less than or equal to a total number of the plurality of pads (120).

11. The flash memory chip according to claim 10, wherein a plurality of external pins (206) in the first pin group (204) and the plurality of pads (120) are uniformly distributed in a 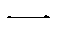 shape, and two pads (120) in the plurality of pads (120) located outside are respectively coupled to two external pins (206) in the first pin group (204) located outside, the plurality of external pins (206) in the first pin group (204) are in one-to-one correspondence with the K pads (120)in the plurality of pads (120) along a length direction of the chip body, and a bonding wire coupled between a pad (120) and an external pin (206) corresponding to each other in each group is parallel to the length direction of the chip body.

12. The flash memory chip according to claim 8, wherein the connection board (140) further comprises a plurality of connection points (203), the plurality of connection points (203) are disposed on the second surface of the connection board (140) and distributed on an outer edge of the connection board (140), and the connection points (203) are coupled to the conductive layer (141) of the connection board (140);
the flash memory chip (110) further comprises a first pin group (204) and a second pin group (205), the first pin group (204) and the second pin group (205) are distributed on two opposite sides of the chip body, and each of the first pin group (204) and the second pin group (205) comprises a plurality of external pins (206); and
the chip body comprises a plurality of pads (120), the plurality of pads (120) are disposed on a side of a surface of the chip body close to the first surface of the connection board (140), the plurality of pads (120) are located between the first pin group (204) and the second pin group (205), T pads (120) in the plurality of pads (120) are coupled to a portion of the external pins (206) in the first pin group (204), E pads (120) in the plurality of pads (120) are coupled to a portion of the external pins (206) in the second pin group (205), and Q pads (120) in the plurality of pads (120) are coupled to the connection points (203);
wherein T, E and Q are all integers greater than or equal to 1, and a sum of T, E and Q is less than or equal to a total number of the plurality of pads (120).

13. A preparation method for a connection board, comprising:
providing (S1501) a semiconductor substrate (143);
forming (S1502) an insulating layer (142) by coating an insulating layer solution on the semiconductor substrate (143) and performing curing treatment; and
forming (S1503) a conductive layer (141) by coating photoresist on the insulating layer (142) and performing treatments of exposure, development, plating, photoresist removal and etching through a mask.

14. The preparation method according to claim 13, wherein, after forming (S1502) the insulating layer (142) by coating the insulating layer solution on the semiconductor substrate (143) and performing curing treatment, the preparation method for the connection board further comprises:
forming a connection layer between the insulating layer (142) and the conductive layer (141);
wherein the connection layer comprises a first metal layer (1610) and a second metal layer (1620), the first metal layer (1610) is made of titanium, and the second metal layer (1620) is made of copper.

15. The preparation method according to claim 13, wherein the conductive layer (141) comprises a plurality of conductive sheets of different shapes, and the conductive sheets comprise one or more of an L-shaped conductive sheet (1411), a 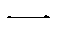 -shaped conductive sheet (1412), a 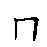 -shaped conductive sheet (1413), and a 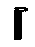 -shaped conductive sheet (1414), and wherein the conductive sheets are copper sheets.
